(19) Europäisches Patentamt / European Patent Office / Office européen des brevets

(11) **EP 3 998 489 B1**

(12) **EUROPEAN PATENT SPECIFICATION**

(45) Date of publication and mention
of the grant of the patent:
**06.08.2025 Bulletin 2025/32**

(51) International Patent Classification (IPC):
**G01R 31/392** (2019.01)     **G01R 31/396** (2019.01)
**H01M 10/42** (2006.01)      **H01M 10/48** (2006.01)
**H01M 10/44** (2006.01)

(21) Application number: **20878781.2**

(22) Date of filing: **07.10.2020**

(52) Cooperative Patent Classification (CPC):
**G01R 31/392; G01R 31/396; H01M 10/425;
H01M 10/441; H01M 10/482;** H01M 2010/4271;
Y02E 60/10

(86) International application number:
**PCT/KR2020/013690**

(87) International publication number:
**WO 2021/080219 (29.04.2021 Gazette 2021/17)**

(54) **BATTERY DOD DIAGNOSING APPARATUS AND METHOD**

VORRICHTUNG UND VERFAHREN ZUR DOD DIAGNOSE EINER BATTERIE

DISPOSITIF ET PROCÉDÉ DE DIAGNOSTIC DOD POUR BATTERIE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **24.10.2019 KR 20190132946**

(43) Date of publication of application:
**18.05.2022 Bulletin 2022/20**

(73) Proprietor: **LG Energy Solution, Ltd.
Seoul 07335 (KR)**

(72) Inventors:
• **KIM, Ji-Yeon
Daejeon 34122 (KR)**
• **KIM, Dae-Soo
Daejeon 34122 (KR)**
• **BAE, Yoon-Jung
Daejeon 34122 (KR)**

(74) Representative: **Plasseraud IP
104 Rue de Richelieu
CS92104
75080 Paris Cedex 02 (FR)**

(56) References cited:
JP-A- 2017 016 991     JP-A- H07 183 049
KR-A- 20100 019 256    KR-A- 20120 076 068
KR-A- 20150 084 354    US-A1- 2003 030 442
US-A1- 2014 278 169    US-A1- 2015 168 498
US-A1- 2019 195 942

EP 3 998 489 B1

**Description**

TECHNICAL FIELD

The present disclosure relates to a battery DOD (Degree Of Degradation) diagnosing apparatus and method, and more particularly, to a battery DOD diagnosing apparatus and method capable of accurately and quickly diagnosing a DOD of a plurality of battery cells.

BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries are in the limelight since they have almost no memory effect compared to nickel-based batteries and also have very low self-charging rate and high energy density.

Meanwhile, since the capacity of the battery gradually decreases as the battery is repeatedly charged and discharged, there is a risk that an unexpected accident may occur due to the decrease of capacity of the battery. Therefore, various studies are being conducted to estimate the lifetime or DOD of the battery.

Conventionally, a battery life estimation method or apparatus for estimating the remaining life of a battery by estimating the state of charge (SOH) of the battery has been disclosed (Patent Literature 1).

However, in Patent Literature 1, since the SOH of the battery is estimated by measuring the amount of voltage increase when the battery is charged and the remaining life of the battery is calculated from the estimated SOH using a statistical technique (e.g., a particle filter), there is a problem that a considerable amount of time is taken to diagnose the remaining life or DOD.

(Patent Literature 1) KR 10-1882287 B1

Further prior art is described in US 2014/278169 A1, JP 2017-016991 A, US 2019/195942 A1, and US 2015/168498 A1.

DISCLOSURE

Technical Problem

The present disclosure is designed to solve the problems of the related art, and therefore the present disclosure is directed to providing a battery DOD diagnosing apparatus and method, which may quickly and accurately diagnose a DOD of a battery cell based on a measured voltage of the battery cell.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

Technical Solution

In one aspect of the present disclosure, there is provided a battery DOD (Degree Of Degradation) diagnosing apparatus, comprising: a measuring unit configured to measure a voltage of each of a plurality of battery cells in each of a plurality of cycles in which charging and discharging are performed, and output a plurality of voltage information for the plurality of measured voltages; and a control unit configured to receive the plurality of voltage information, calculate a voltage deviation of each cycle for each battery cell based on a reference voltage measured in an initial cycle of each of the plurality of battery cells, and diagnose a relative DOD of the plurality of battery cells based on a voltage sum value according to the plurality of voltage deviations calculated for each of the plurality of battery cells.

The measuring unit may be configured to measure a voltage at a measurement point when a predetermined time passes after the discharging of the plurality of battery cells is terminated.

The control unit may be configured to set a voltage measured in the initial cycle of each battery cell as the reference voltage and calculate the voltage deviation by calculating a difference between a cell voltage of each battery cell measured in each cycle and the reference voltage.

The control unit may be configured to diagnose a relative DOD of the plurality of battery cells by comparing the voltage sum value calculated for each of the plurality of battery cells with each other.

The control unit may be configured to diagnose that a battery DOD is greater as the voltage sum value is greater.

The control unit may be configured to divide the plurality of cycles into a plurality of unit sections, calculate a unit sum value for each of the plurality of divided unit sections based on at least one voltage deviation calculated corresponding to a cycle belonging to each of the plurality of divided unit sections, and diagnose a relative DOD in each of the plurality of unit sections for the plurality of battery cells based on a comparison result of unit sum values calculated corresponding to the same unit section.

The control unit may be configured to select a target cell among the plurality of battery cells, calculate a unit sum value corresponding to the target cell in each of the plurality of unit sections, and diagnose whether the degradation of the target cell is accelerated by comparing the plurality of calculated unit sum values corresponding to the target cell with each other.

The control unit may be configured to diagnose that the degradation of the target cell is accelerated, when the unit sum value increases as the cycle proceeds.

A battery pack according to another aspect of the present disclosure may comprise the battery DOD diagnosing apparatus according to an aspect of the present disclosure.

A battery DOD diagnosing method according to still another aspect of the present disclosure may comprise a voltage measuring step of measuring a voltage of each of a plurality of battery cells in each of a plurality of cycles in which charging and discharging is performed; a voltage deviation calculating step of calculating a voltage deviation of each cycle for each battery cell based on a reference voltage measured in an initial cycle of each of the plurality of battery cells; a voltage sum value calculating step of calculating a voltage sum value according to the plurality of voltage deviations calculated for each of the plurality of battery cells; and a DOD diagnosing step of diagnosing a relative DOD of the plurality of battery cells based on the voltage sum value calculated in the voltage sum value calculating step.

Advantageous Effects

According to an aspect of the present disclosure, since the relative DOD of the plurality of battery cells may be diagnosed based on the measured voltage value, the relative DOD of the plurality of battery cells may be accurately and quickly diagnosed.

In addition, according to an aspect of the present disclosure, even if the SOH of the battery is not estimated, there is an advantage in that the performance of a plurality of battery cells may be comparatively diagnosed within a short time.

In addition, according to an aspect of the present disclosure, since information necessary for estimating the cause of degradation of the battery cell is provided, there is an advantage of helping a user when determine the replacement timing of the battery cell or the charging and discharging condition of the battery cell.

The effects of the present disclosure are not limited to the effects mentioned above, and other effects not mentioned will be clearly understood by those skilled in the art from the description of the claims.

DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.

FIG. 1 is a diagram schematically showing a battery DOD diagnosing apparatus according to an embodiment of the present disclosure.

FIG. 2 is a diagram schematically showing a battery pack including the battery DOD diagnosing apparatus according to an embodiment of the present disclosure.

FIG. 3 is a diagram showing an exemplary configuration of the battery pack including the battery DOD diagnosing apparatus according to an embodiment of the present disclosure.

FIG. 4 is a diagram showing a voltage deviation calculated for a first battery cell by the battery DOD diagnosing apparatus according to an embodiment of the present disclosure.

FIG. 5 is a diagram showing a voltage deviation calculated for a second battery cell by the battery DOD diagnosing apparatus according to an embodiment of the present disclosure.

FIG. 6 is a diagram showing a voltage deviation calculated for a third battery cell by the battery DOD diagnosing apparatus according to an embodiment of the present disclosure.

FIG. 7 is a diagram showing a voltage deviation calculated for a fourth battery cell by the battery DOD diagnosing apparatus according to an embodiment of the present disclosure.

FIG. 8 is a diagram showing a cycle retention for a plurality of battery cells.

FIG. 9 is a diagram schematically showing a battery DOD diagnosing method according to another embodiment of the present disclosure.

BEST MODE

It should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the scope of the disclosure.

Additionally, in describing the present disclosure, when it is deemed that a detailed description of relevant known elements or functions renders the key subject matter of the present disclosure ambiguous, the detailed description is omitted herein.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise.

Furthermore, the term "control unit" described in the specification refers to a unit that processes at least one function or operation, and may be implemented by hardware, software, or a combination of hardware and software.

In addition, throughout the specification, when a portion is referred to as being "connected" to another portion, it is not limited to the case that they are "directly connected", but it also includes the case where they are "indirectly connected" with another element being interposed between them.

Hereinafter, preferred embodiments of the present disclosure will be described in detail with reference to the accompanying drawings.

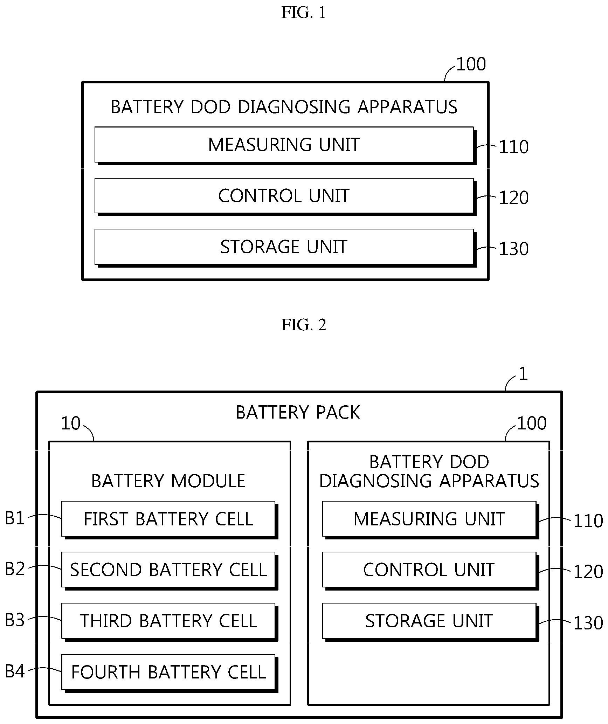

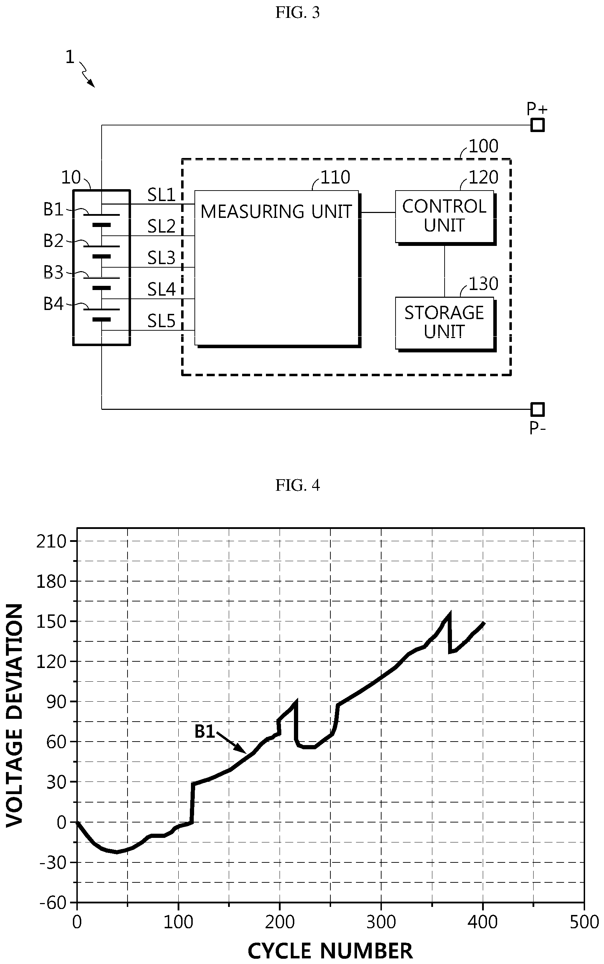

FIG. 1 is a diagram schematically showing a battery DOD diagnosing apparatus 100 according to an embodiment of the present disclosure. FIG. 2 is a diagram schematically showing a battery pack 1 including the battery DOD diagnosing apparatus 100 according to an embodiment of the present disclosure. FIG. 3 is a diagram showing an exemplary configuration of the battery pack 1 including the battery DOD diagnosing apparatus 100 according to an embodiment of the present disclosure.

Referring to FIGS. 2 and 3, the battery pack 1 may include a battery module 10 and a battery DOD diagnosing apparatus 100.

Here, at least one battery cell may be connected in series and/or in parallel in the battery module 10. In addition, the battery cell refers to one independent cell that has a negative electrode terminal and a positive electrode terminal and is physically separable. For example, one pouch-type lithium polymer cell may be regarded as the battery cell. Hereinafter, as shown in FIGS. 2 and 3, it will be described that the battery module 10 includes a first battery cell B1, a second battery cell B2, a third battery cell B3, and a fourth battery cell B4. However, it should be noted that at least one battery cell may be provided in the battery module 10, and there is no limit to the number of provided battery cells.

Referring to FIG. 1, the battery DOD diagnosing apparatus 100 may include a measuring unit 110 and a control unit 120.

The measuring unit 110 may be configured to measure a voltage of each of the plurality of battery cells B1 to B4 in each of a plurality of cycles in which discharging and charging are performed.

Specifically, the measuring unit 110 may measure the voltage of at least one of the plurality of battery cells B1 to B4.

For example, in the embodiment of FIG. 3, the measuring unit 110 may be connected to the battery module 10 through a first sensing line SL1, a second sensing line SL2, a third sensing line SL3, a fourth sensing line SL4, and a fifth sensing line SL5. In addition, the measuring unit 110 may measure the voltage of the first battery cell B1 through the first sensing line SL1 and the second sensing line SL2. In addition, the measuring unit 110 may measure the voltage of the second battery cell B2 through the second sensing line SL2 and the third sensing line SL3. In addition, the measuring unit 110 may measure the voltage of the third battery cell B3 through the third sensing line SL3 and the fourth sensing line SL4. In addition, the measuring unit 110 may measure the voltage of the fourth battery cell B4 through the fourth sensing line SL4 and the fifth sensing line SL5.

In addition, the measuring unit 110 may measure the voltage of each of the plurality of battery cells B1 to B4 in every cycle.

For example, it is assumed that charging and discharging of the plurality of battery cells B1 to B4 are performed for a total of 200 cycles. The measuring unit 110 may measure the voltage of the plurality of battery cells B1 to B4 in each of a 1st cycle to a 200th cycle.

In addition, the measuring unit 110 may be configured to output a plurality of voltage information for a plurality of measured voltages.

The measuring unit 110 may convert the voltage of the plurality of battery cells B1 to B4 measured using a plurality of sensing lines SL1 to SL5 into a digital signal. In addition, the measuring unit 110 may output the measured voltage information by outputting the converted digital signal.

The control unit 120 may be configured to receive the plurality of voltage information.

That is, the control unit 120 may obtain voltage information on the plurality of battery cells B1 to B4 measured by the measuring unit 110 by reading the digital signal received from the measuring unit 110.

Referring to FIG. 3, the measuring unit 110 and the control unit 120 may be connected to each other through a wired line. That is, the measuring unit 110 and the control unit 120 may be configured to transmit and receive signals to and from each other through a wired line.

For example, it is assumed that the measuring unit 110 transmits voltage information of each of the plurality of battery cells B1 to B4 measured in each of the 1st cycle to the 200th cycle to the control unit 120. In this case, the control unit 120 may obtain all of the voltage information in the 1st cycle to the voltage information in the 200th cycle for each of the plurality of battery cells B1 to B4.

The control unit 120 may be configured to calculate a voltage deviation of each cycle for each battery cell based on a reference voltage measured in an initial cycle of each of the plurality of battery cells B1 to B4.

Specifically, the control unit 120 may calculate the voltage deviation of each cycle for each battery cell using the following equation.

[Equation 1]

$$\triangle V = Vn - Vref$$

Here, $\triangle V$ is a calculated voltage deviation [mV], Vn is a voltage [mV] measured in the $n^{th}$ cycle, Vref is a reference voltage [mV] measured in a reference cycle, and n is a positive integer.

For example, if the reference cycle is the $1^{st}$ cycle, Vref may be a voltage measured in the $1^{st}$ cycle. That is, the control unit 120 may calculate a voltage deviation ($\triangle V$) between the reference voltage (Vref) measured in the $1^{st}$ cycle and the voltage (Vn) measured in the $n^{th}$ cycle, based on the voltage measured in the $1^{st}$ cycle. In this case, the control unit 120 may diagnose a DOD (Degree Of Degradation) of the plurality of battery cells B1 to B4 in the $1^{st}$ cycle to the $n^{th}$ cycle.

As another example, if the reference cycle is the $101^{st}$ cycle, Vref may be a voltage measured in the $101^{st}$ cycle. That is, the control unit 120 may calculate a voltage deviation ($\triangle V$) between the reference voltage (Vref) measured in the $101^{st}$ cycle and the voltage (Vn) measured in the $n^{th}$ cycle, based on the voltage measured in the $101^{st}$ cycle. In this case, the control unit 120 may diagnose the DOD of the plurality of battery cells B1 to B4 in the $101^{st}$ cycle to $n^{th}$ cycle.

Hereinafter, in the embodiment of FIG. 3, an example of the voltage deviation calculated by the control unit 120 for each of the plurality of battery cells B1 to B4 will be described with reference to FIGS. 4 to 7.

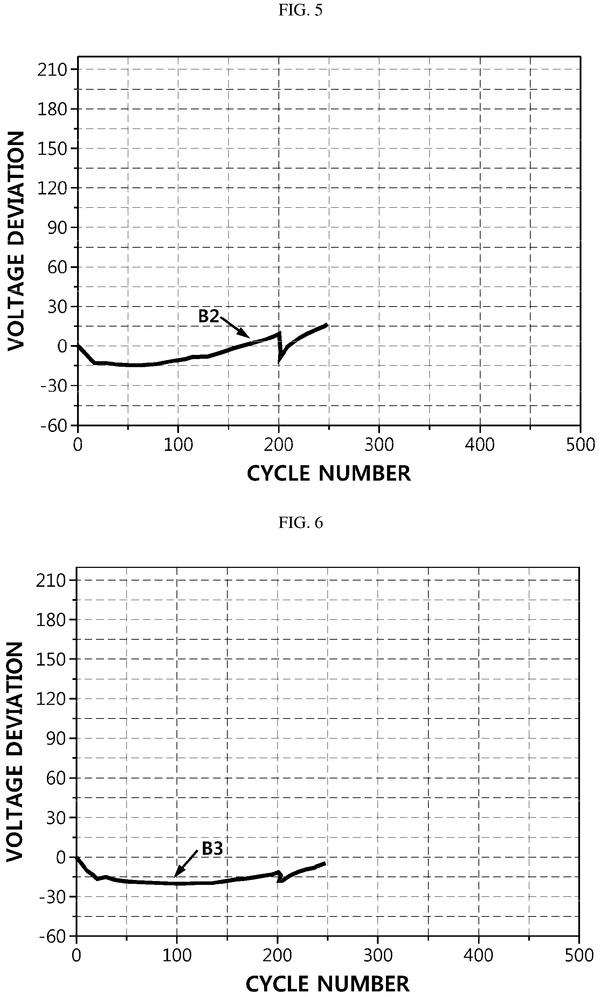

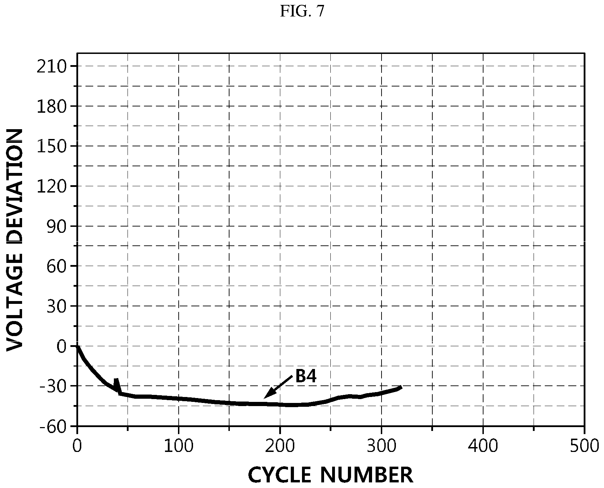

FIG. 4 is a diagram showing a voltage deviation [mV] calculated for a first battery cell B1 by the battery DOD diagnosing apparatus 100 according to an embodiment of the present disclosure. FIG. 5 is a diagram showing a voltage deviation [mV] calculated for a second battery cell B2 by the battery DOD diagnosing apparatus 100 according to an embodiment of the present disclosure. FIG. 6 is a diagram showing a voltage deviation [mV] calculated for a third battery cell B3 by the battery DOD diagnosing apparatus 100 according to an embodiment of the present disclosure. FIG. 7 is a diagram showing a voltage deviation [mV] calculated for a fourth battery cell B4 by the battery DOD diagnosing apparatus 100 according to an embodiment of the present disclosure.

Specifically, FIG. 4 is a diagram showing a voltage deviation of the first battery cell B1 calculated in the $1^{st}$ cycle to the $400^{th}$ cycle. FIG. 5 is a diagram showing a voltage deviation of the second battery cell B2 calculated in the $1^{st}$ cycle to the $250^{th}$ cycle. FIG. 6 is a diagram showing a voltage deviation of the third battery cell B3 calculated in the $1^{st}$ cycle to the $250^{th}$ cycle. FIG. 7 is a diagram showing a voltage deviation of the fourth battery cell B4 calculated in the $1^{st}$ cycle to the $320^{th}$ cycle.

Referring to FIGS. 4 to 7, the voltage deviation may be calculated as 0, positive or negative according to the voltage of the battery cell measured in the $n^{th}$ cycle. Preferably, in the embodiments of FIGS. 4 to 7, the reference cycle may be $1^{st}$ cycle. That is, when calculating the voltage deviation, since the voltage of the battery cell measured in the reference cycle is used as a reference, the voltage deviation in the $1^{st}$ cycle may be equal to 0 in FIGS. 4 to 7.

In addition, the reference voltage (e.g., the voltage of the battery cell measured in the $1^{st}$ cycle) serving as a reference may be measured differently for the plurality of battery cells B1 to B4. That is, the reference voltages may be set differently according to the DODs of the plurality of battery cells B1 to B4.

The control unit 120 may be configured to diagnose a relative DOD of the plurality of battery cells B1 to B4 based on a voltage sum value according to a plurality of voltage deviations calculated for each of the plurality of battery cells B1 to B4.

First, the control unit 120 may sum up a plurality of voltage deviations calculated for each of the plurality of battery cells B1 to B4. That is, the voltage sum value may be a sum of the plurality of voltage deviations calculated for each of the plurality of battery cells B1 to B4.

For example, in the embodiments of FIGS. 4 to 7, it is assumed that the control unit 120 sums up the voltage deviations from the $1^{st}$ cycle to the $200^{th}$ cycle for each of the plurality of battery cells B1 to B4. The voltage sum value of the first battery cell B1 may be 2575 [mV], the voltage sum value of the second battery cell B2 may be -1187 [mV], the voltage sum value of the third battery cell B3 may be -3272 [mV], and the voltage sum value of the fourth battery cell B4 may be -7404 [mV].

The control unit 120 may diagnose a relative DOD of the plurality of battery cells B1 to B4 by comparing the voltage sum values calculated for each of the plurality of battery cells B1 to B4.

Specifically, the control unit 120 may diagnose that degeneration has progressed less as the voltage sum value is smaller, and may diagnose that degeneration has progressed further as the voltage sum value is greater.

For example, as in the former embodiment, it is assumed that the voltage sum value of the first battery cell B1 is 2575 [mV], the voltage sum value of the second battery cell B2 is -1187 [mV], the voltage sum value of the third battery cell B3 is -3272 [mV] and the voltage sum value of the fourth battery cell B4 is -7404 [mV]. The control unit 120 may diagnose that the relative DOD of the first battery cell B1 having the greatest voltage sum value is highest, and that the relative DOD of the fourth battery cell B4 having the smallest voltage sum value is lowest. Preferably, the control unit 120 may diagnose that the first battery cell B1 is more degraded than the second battery cell B2, the third battery cell B3 and the fourth battery cell B4 in the $1^{st}$ cycle to the $200^{th}$ cycle.

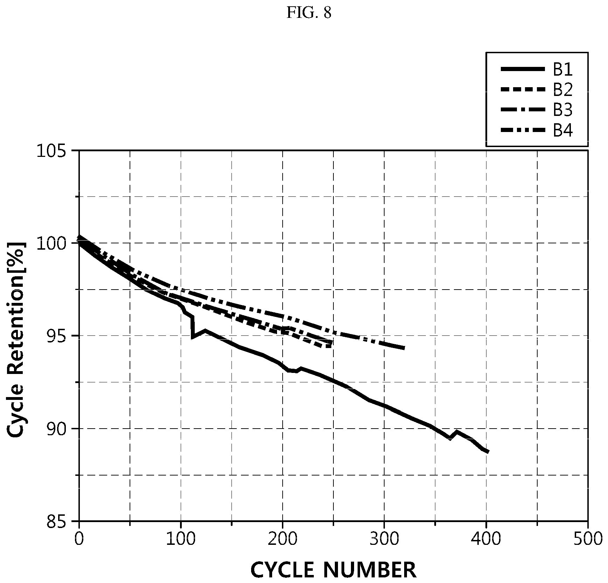

FIG. 8 is a diagram showing a cycle retention for a plurality of battery cells B1 to B4. Specifically, FIG. 8 is a diagram illustrating a change of capacity of each of the plurality of battery cells B1 to B4 as the charging and discharging cycle proceeds. Here, the cycle retention may correspond to a state of health (SOH) estimated for each of the plurality of battery cells B1 to B4.

Referring to FIG. 8, it may be found that the capacity of the first battery cell B1 decreases most as the cycle proceeds from the 1st cycle to the 200th cycle. In addition, it may be found that the capacity of the fourth battery cell B4 decreases smallest. However, the SOH of the battery cell shown in FIG. 8 cannot be measured directly, and is a value estimated based on battery state information such as current and/or voltage of the battery cell. That is, since the SOH of the battery cell is estimated by integrating the charging and/or discharging current of the battery cell or considering the change in internal resistance of the battery cell, there is a problem that a lot of time and system resources are required for the estimation.

Meanwhile, since the battery DOD diagnosing apparatus 100 according to an embodiment of the present disclosure may diagnose a relative DOD of the plurality of battery cells B1 to B4 based on the measured voltage value, there is an advantage in that the relative DOD of the plurality of battery cells B1 to B4 may be diagnosed accurately and quickly.

That is, since the battery DOD diagnosing apparatus 100 may diagnose the relative DOD between the plurality of battery cells B1 to B4 without estimating the SOH of the plurality of battery cells B1 to B4, there is an advantage in that the relative DOD of the plurality of battery cells B1 to B4 may be diagnosed accurately and quickly even in a situation where the relative DOD of the plurality of battery cells B1 to B4 must be diagnosed within a short time.

Meanwhile, the control unit 120 provided to the battery DOD diagnosing apparatus 100 may selectively include processors known in the art, application-specific integrated circuit (ASIC), other chipsets, logic circuits, registers, communication modems, data processing devices, and the like to execute various control logic performed in the present disclosure. Also, when the control logic is implemented in software, the control unit 120 may be implemented as a set of program modules. At this time, the program module may be stored in a memory and executed by the control unit 120. The memory may be located inside or out of the control unit 120 and may be connected to the control unit 120 by various well-known means.

In addition, referring to FIGS. 1 to 3, the battery DOD diagnosing apparatus 100 may further include a storage unit 130. The storage unit 130 may store programs, data and the like required for the control unit 120 to diagnose the DOD of the plurality of battery cells B1 to B4. That is, the storage unit 130 may store data necessary for operation and function of each component of the battery DOD diagnosing apparatus 100, data generated in the process of performing the operation or function, or the like.

For example, the storage unit 130 may store voltage information of each of the plurality of battery cells B1 to B4 measured in each cycle.

In addition, the storage unit 130 is not particularly limited in its kind as long as it is a known information storage means that can record, erase, update and read data. As an example, the information storage means may include RAM, flash memory, ROM, EEPROM, registers, and the like. In addition, the storage unit 130 may store program codes in which processes executable by the control unit 120 are defined.

The measuring unit 110 may be configured to measure a voltage at a measurement point when a predetermined time passes after discharging of the plurality of battery cells B1 to B4 is terminated.

Preferably, the measuring unit 110 may measure OCV (Open Circuit Voltage) of the battery cell. That is, the measuring unit 110 may measure the OCV of the battery cell when a predetermined time passes after charging or discharging of the battery cell is terminated. For example, the measuring unit 110 may measure the OCV when the battery cell is in an idle state after discharging of the battery cell is terminated.

That is, when measuring the voltage of the plurality of battery cells B1 to B4, the measuring unit 110 may be configured to measure the OCV of the plurality of battery cells B1 to B4 in order to minimize the effect of the current. For example, in order to accurately measure the OCV of the battery cell, the measuring unit 110 may measure the OCV of the battery cell when the discharging of the battery cell is terminated and a chemical relaxation state is reached.

In the embodiment of FIG. 3, the measuring unit 110 may be configured to measure the OCV of each of the plurality of battery cells B1 to B4 after discharging of the plurality of battery cells B1 to B4 is terminated. Accordingly, in order to measure the OCV, the measuring unit 110 may measure the voltage of each of the plurality of battery cells B1 to B4 at a point in time when a predetermined time passes after the discharging of the plurality of battery cells B1 to B4 is terminated.

That is, the measuring unit 110 may measure the voltage of each of the plurality of battery cells B1 to B4 after the same time passes from a discharge end time at which the discharging of the plurality of battery cells B1 to B4 is terminated. For example, the measuring unit 110 may measure the voltage of each of the plurality of battery cells B1 to B4 when 300 seconds pass after the discharging of the plurality of battery cells B1 to B4 is terminated.

The control unit 120 may be configured to set a voltage measured in the initial cycle of each battery cell as the reference voltage.

For example, referring to Equation 1, the control unit 120 may set the voltage measured in the 1st cycle by the measuring unit 110 as the reference voltage for each of the plurality of battery cells B1 to B4.

In addition, the control unit 120 may be configured to calculate the voltage deviation by calculating a difference between the cell voltage measured in each cycle for each battery cell and the reference voltage.

As in the former embodiment, if the reference cycle is set to $1^{st}$ cycle, the voltage deviation may be calculated as a difference between the voltage measured in the $n^{th}$ cycle and the voltage measured in the $1^{st}$ cycle. That is, the control unit 120 may diagnose the relative DOD for the plurality of battery cells B1 to B4 from the $1^{st}$ cycle to the $n^{th}$ cycle.

Therefore, the battery DOD diagnosing apparatus 100 according to an embodiment of the present disclosure has an advantage of easily comparing the DOD of the plurality of battery cells B1 to B4 during a plurality of cycles. That is, the battery DOD diagnosing apparatus 100 has an advantage of being used more effectively in a situation where it is necessary to compare the performance of the plurality of battery cells B1 to B4 within a short time.

The control unit 120 may be configured to diagnose a relative DOD of the plurality of battery cells B1 to B4 by comparing the voltage sum value calculated for each of the plurality of battery cells B1 to B4.

Here, the voltage sum value may be an index for comparing the performance of the plurality of battery cells B1 to B4 with each other. For example, the plurality of calculated voltage deviations may be summed to calculate the voltage sum value.

In general, for reasons such as generation of internal gas, generation of lithium plating, decomposition of electrolyte and/or accumulation of by-products, the measured OCV may increase as the cycle of the battery cell proceeds. For example, if the battery cell is degraded due to the decrease of capacity of the positive electrode inside the battery cell, the OCV of the positive electrode may increase and the OCV of the negative electrode may decrease compared to the initial battery cell. That is, the OCV of the battery cell in an EOL (End Of Life) state may be greater than the OCV of the battery cell in a BOL (Beginning Of Life) state. Therefore, as the battery cell is degraded, the OCV of the battery cell may increase.

For example, referring to Equation 1, since the voltage ($Vn$) measured in the $n^{th}$ cycle may increase as the cycle of the battery cell proceeds, the voltage sum value may increase as the battery cell is degraded. Preferably, the control unit 120 may be configured to diagnose that the battery DOD is greater as the voltage sum value is greater. Conversely, the control unit 120 may be configured to diagnose that the battery DOD is smaller as the voltage sum value is smaller.

Therefore, the battery DOD diagnosing apparatus 100 according to an embodiment of the present disclosure has an advantage of accurately and quickly diagnosing the relative DOD of the plurality of battery cells B1 to B4 in consideration of the change of OCV according to the degradation of the battery cell.

Hereinafter, an embodiment in which the battery DOD diagnosing apparatus 100 according to an embodiment of the present disclosure compares the relative DODs of the plurality of battery cells B1 to B4 in a predetermined cycle period with each other will be described.

First, the control unit 120 may be configured to divide the plurality of cycles into a plurality of unit sections.

For example, in the embodiments of FIGS. 4 to 7, the control unit 120 may divide every 50 cycles into a unit section. That is, the control unit 120 may divide $1^{st}$ cycle to $50^{th}$ cycle into a first unit section, and may divide $51^{th}$ cycle to $100^{th}$ cycle into a second unit section. In addition, the control unit 120 may divide $101^{st}$ cycle to $150^{th}$ cycle into a third unit section, divide $151^{st}$ cycle to $200^{th}$ cycle into a fourth unit section, and divide $201^{st}$ cycle to $250^{th}$ cycle into a fifth unit section.

In addition, the control unit 120 may be configured to calculate a unit sum value for each of the plurality of divided unit sections, based on at least one voltage deviation calculated corresponding to a cycle belonging to each of the plurality of divided unit sections.

Here, the unit sum value may mean a voltage sum value calculated for each unit section. That is, the control unit 120 may calculate a voltage sum value for each of the plurality of divided unit sections.

Specifically, the control unit 120 may calculate the voltage deviation for each cycle belonging to the plurality of divided unit sections. For example, in the case of the first unit section as an example, the control unit 120 may calculate the voltage deviation for each of the $1^{st}$ cycle to the $50^{th}$ cycle. In addition, the control unit 120 may calculate the unit sum value of the first unit section by summing the voltage deviation calculated in each of the $1^{st}$ cycle to the $50^{th}$ cycle.

Similarly, in the case of the second unit section as an example, the control unit 120 may calculate the voltage deviation for each of the $51^{th}$ cycle to the $100^{th}$ cycle. In addition, the control unit 120 may calculate the unit sum value of the second unit section by summing the voltage deviation calculated in each of the $51^{th}$ cycle to the $100^{th}$ cycle.

The control unit 120 may calculate unit sum values of the third unit section, the fourth unit section and the fifth unit section in the same manner as calculating the voltage sum value of the first unit section and the unit sum value of the second unit section.

Finally, the control unit 120 is configured to diagnose relative DOD in each of the plurality of unit sections for the plurality of battery cells B1 to B4 based on the result of comparing the unit sum values calculated corresponding to the same unit section.

That is, the control unit 120 may diagnose the relative DOD of the plurality of battery cells B1 to B4 for each of the plurality of unit sections.

For example, the control unit 120 may diagnose the relative DOD of the plurality of battery cells B1 to B4 in each of the first unit section, the second unit section, the third unit section, the fourth unit section and the fifth unit section.

Therefore, the battery DOD diagnosing apparatus 100 according to an embodiment of the present disclosure has an advantage of not only diagnosing the relative DOD of the plurality of battery cells B1 to B4 for the total period, but also diagnosing the DOD of the plurality of battery cells B1 to B4 for each unit section.

In addition, the control unit 120 may obtain cycle information for each of the plurality of unit sections, such as cycle time (time required for one cycle to proceed), intensity of the charging current, intensity of the discharging current, or temperature of the battery cell, and store the cycle information in the storage unit 130. In addition, the control unit 120 may provide the cycle information stored in the storage unit 130 together with the DOD of the plurality of battery cells diagnosed in each of the plurality of unit sections.

Accordingly, the battery DOD diagnosing apparatus 100 has an advantage of providing the cycle information to a user, thereby providing information necessary to estimate the cause of degradation of a battery cell.

In addition, since the battery DOD diagnosing apparatus 100 provides the information necessary to estimate the cause of degradation of the battery cell, there is an advantage of helping the user to determine a replacement timing of the battery cell or a charging/-discharging condition of the battery cell.

Hereinafter, an embodiment in which the battery DOD diagnosing apparatus 100 according to an embodiment of the present disclosure diagnoses whether the degradation of each battery cell is accelerated will be described.

The control unit 120 may be configured to select a target cell among the plurality of battery cells B1 to B4.

That is, the control unit 120 may select a target cell for diagnosing whether or not the degradation is accelerated, among the plurality of battery cells B1 to B4. For example, the control unit 120 may select the first battery cell B1 as a target cell.

In addition, the control unit 120 may be configured to calculate a unit sum value corresponding to the target cell in each of the plurality of unit sections.

First, the control unit 120 may divide the plurality of cycles into a plurality of unit sections.

For example, in the embodiment of FIG. 4, the control unit 120 may divide the 1st cycle to the 400th cycle for every 50 cycles. That is, the control unit 120 may divide the 1st cycle to the 400th cycle into first to eighth unit sections.

In addition, the control unit 120 may be configured to calculate a unit sum value for each of the plurality of divided unit sections, based on at least one voltage deviation calculated corresponding to a cycle belonging to each of the plurality of divided unit sections.

Here, the control unit 120 may set the voltage measured in the initial cycle among the plurality of cycles as a reference voltage (Vref) of Equation 1 in order to diagnose whether the DOD of the target cell is accelerated.

For example, when the control unit 120 is to calculate the unit sum value of the first to eighth unit sections for the target cell, the control unit 120 may set the voltage measured in the initial cycle (1st cycle) of the first unit section as the reference voltage (Vref). That is, when diagnosing whether the DOD of the target cell is accelerated, the reference voltage for calculating the unit sum value of each of the plurality of unit sections should be the same. Therefore, the control unit 120 may calculate the unit sum value for the first to eighth unit sections based on the voltage measured in the 1st cycle in order to diagnose whether the DOD of the target cell is accelerated.

As another example, when the control unit 120 is to calculate the unit sum value of the third to eighth unit sections for the target cell, the control unit 120 may set the voltage measured in the initial cycle (101st cycle) of the third unit section as the reference voltage (Vref). In this case, the control unit 120 may diagnose whether the degradation of the target cell is accelerated in the third to eighth unit sections.

Finally, the control unit 120 may be configured to diagnose whether the degradation of the target cell is accelerated by comparing the plurality of unit sum values calculated to correspond to the target cell.

If the unit sum value increases as the cycle proceeds, the control unit 120 may diagnose that the DOD of the target cell is accelerated. Conversely, if the unit sum value decreases as the cycle proceeds, the control unit 120 may diagnose that the DOD of the target cell is decelerated.

Hereinafter, an embodiment in which the control unit 120 diagnoses whether the degradation of the first battery cell B1 is accelerated will be described with reference to FIG. 4.

The control unit 120 may select the first battery cell B1 as a target cell and divide the 1st to 400th cycles into first to eighth unit sections.

In addition, the control unit 120 may calculate a voltage deviation corresponding to each of the 1st to 400th cycles based on the voltage of the target cell measured in the 1st cycle.

In addition, the control unit 120 may calculate the unit sum value of each of the first to eighth unit sections based on the calculated voltage deviation for each cycle.

Referring to FIG. 4, it may be found that the unit sum value of each of the first to eighth unit sections increases as the cycle proceeds. That is, in the graph of FIG. 4, an area obtained by integrating the voltage deviation graph of the first battery cell B1 based on the voltage deviation "0" may correspond to the unit sum value of each unit section.

Specifically, in the embodiment of FIG. 4, the unit sum values of the first unit section and the second unit section may be calculated as a negative number, and the unit sum values of the third to eighth unit sections may be calculated as a positive number. In addition, as the cycle proceeds from the first unit section to the eighth unit section, the unit sum values may show a gradually increasing pattern.

Accordingly, the control unit 120 may diagnose that the DOD of the first battery cell B1, which is a target cell, is accelerated.

That is, the battery DOD diagnosing apparatus 100 according to an embodiment of the present disclosure has an advantage of not only diagnosing the relative DOD of the cells by comparing the plurality of battery cells B1 to B4 with each other, but also determining whether the degradation is accelerated for any one battery cell.

Therefore, the battery DOD diagnosing apparatus 100 has an advantage of providing more accurate and reliable battery deterioration information based on whether the degradation of individual battery cells is accelerated and also based on the relative DOD of the plurality of battery cells B1 to B4.

In addition, the battery DOD diagnosing apparatus 100 according to the present disclosure may be provided to a battery pack 1. That is, referring to FIGS. 2 and 3, the battery pack 1 according to the present disclosure may include the battery DOD diagnosing apparatus 100 described above and at least one battery cell. In addition, the battery pack 1 may further include electrical equipment (a relay, a fuse, etc.) and a case.

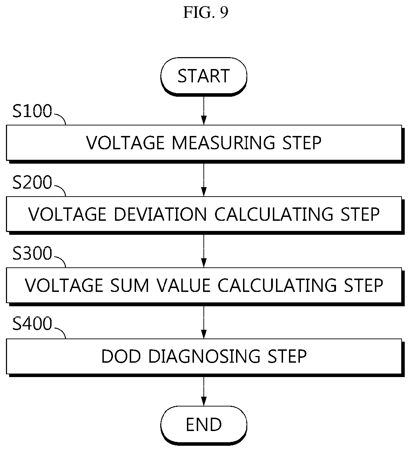

FIG. 9 is a diagram schematically showing a battery DOD diagnosing method according to another embodiment of the present disclosure. Here, each step included in the battery DOD diagnosing method may be performed by the battery DOD diagnosing apparatus 100 according to an embodiment of the present disclosure.

Referring to FIG. 9, the battery DOD diagnosing method may include a voltage measuring step, a voltage deviation calculating step, a voltage sum value calculating step, and a DOD diagnosing step.

The voltage measuring step is a step of measuring a voltage of each of the plurality of battery cells B1 to B4 in each of a plurality of cycles in which discharge and charging are performed, and may be performed by the measuring unit 110.

Preferably, the measuring unit 110 may measure an OCV of the plurality of battery cells B1 to B4 in each cycle. For example, in the embodiment of FIG. 3, the measuring unit 110 may measure the OCV of the plurality of battery cells B1 to B4 provided in the battery module 10 through the plurality of sensing lines SL1 to SL5.

The voltage deviation calculating step is a step of calculating a voltage deviation of each cycle for each battery cell based on a reference voltage measured in an initial cycle of each of the plurality of battery cells B1 to B4, and may be performed by the control unit 120.

For example, the control unit 120 may calculate a voltage deviation of each cycle for each of the plurality of battery cells B1 to B4 with reference to Equation 1.

Here, the control unit 120 may set the voltage measured in the initial cycle to diagnose the DOD as a reference voltage.

For example, when diagnosing the DOD of the plurality of battery cells B1 to B4 in the 1st to 250th cycles, the control unit 120 may set the voltage of each of the plurality of battery cells B1 to B4 measured in the 1st cycle as the reference voltage to calculate the voltage deviation for the corresponding battery cell.

As another example, when diagnosing the DOD of the plurality of battery cells B1 to B4 in the 101st to 250th cycles, the control unit 120 may set the voltage of each of the plurality of battery cells B1 to B4 measured in the 101st cycle as the reference voltage to calculate the voltage deviation for the corresponding battery cell.

The voltage sum value calculating step is a step of calculating a voltage sum value according to a plurality of voltage deviations calculated for each of the plurality of battery cells B1 to B4, and may be performed by the control unit 120.

The control unit 120 may calculate the voltage sum value by summing the voltage deviation calculated in each cycle for each of the plurality of battery cells B1 to B4.

Specifically, the control unit 120 may calculate a voltage sum value for a cycle section in which the DOD is to be diagnosed.

For example, the control unit 120 may calculate a voltage sum value for the 1st cycle to the 250th cycle by summing all of the plurality of voltage deviations respectively calculated in the 1st cycle to the 250th cycle.

As another example, the control unit 120 may divide 1st cycle to 250th cycle into unit sections by 50 cycles, and calculate a voltage sum value for each of the divided unit sections. In this case, the control unit 120 may diagnose the relative DOD of the plurality of battery cells B1 to B4 for each unit section, or diagnose whether the DOD of the target cell is accelerated.

The DOD diagnosing step is a step of diagnosing the relative DOD of the plurality of battery cells B1 to B4 based on the voltage sum value calculated in the voltage sum value calculating step, and may be performed by the control unit 120.

Preferably, the control unit 120 may diagnose that the degradation has progressed further as the calculated voltage sum value is greater. Conversely, the control unit 120 may diagnose that the degradation has progressed less as the calculated voltage sum value is smaller.

Therefore, the battery DOD diagnosing method according to another embodiment of the present disclosure has an advantage of quickly and accurately diagnosing the DOD based on the measured voltage, even if the SOH of each of the plurality of battery cells B1 to B4 is not estimated.

Accordingly, the battery DOD diagnosing method has an advantage of being applied very effectively in an environment where the DOD of a plurality of batteries must be diagnosed or estimated within a short time.

The embodiments of the present disclosure described above may not be implemented only through an apparatus and a method, but may be implemented through a program that realizes a function corresponding to the configuration of the embodiments of the present disclosure or a recording medium on which the program is recorded. The program or recording medium may be easily implemented by those skilled in the art from the above description of the embodiments.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description.

Additionally, many substitutions, modifications and changes may be made to the present disclosure described hereinabove by those skilled in the art without departing from the technical aspects of the present disclosure, and the present disclosure is not limited to the above-described embodiments and the accompanying drawings, and each embodiment may be selectively combined in part or in whole to allow various modifications.

(Reference Signs)

1: battery pack
10: battery module
100: battery DOD diagnosing apparatus
110: measuring unit
120: control unit
130: storage unit
B1 to B4: first to fourth battery cells
SL1 to SL5: first to fifth sensing lines

**Claims**

1. A battery Degree of Degradation , DOD, diagnosing apparatus (100), comprising:

   a measuring unit (110) configured to measure a voltage of each of a plurality of battery cells (B1, B2, B3, B4) in each of a plurality of cycles in which charging and discharging are performed, and output a plurality of voltage information for the plurality of measured voltages; and
   a control unit (120) configured to receive the plurality of voltage information, calculate a voltage deviation of each cycle for each battery cell based on a reference voltage measured in an initial cycle of each of the plurality of battery cells, calculate a voltage sum value for each of the plurality of battery cells by summing the voltage deviation calculated for each of the plurality of battery cells in each cycle from the initial cycle, and diagnose a relative DOD of the plurality of battery cells based on the voltage sum value calculated for each of the plurality of battery cells.

2. The battery DOD diagnosing apparatus according to claim 1,
   wherein the measuring unit is configured to measure a voltage at a measurement point when a predetermined time passes after the discharging of the plurality of battery cells is terminated.

3. The battery DOD diagnosing apparatus according to claim 2,
   wherein the control unit is configured to set a voltage measured in the initial cycle of each battery cell as the reference voltage and calculate the voltage deviation by calculating a difference between a cell voltage of each battery cell measured in each cycle and the reference voltage.

4. The battery DOD diagnosing apparatus according to claim 1,
   wherein the control unit is configured to diagnose a relative DOD of the plurality of battery cells by comparing the voltage sum value calculated for each of the plurality of battery cells with each other.

5. The battery DOD diagnosing apparatus according to claim 4,
   wherein the control unit is configured to diagnose that a battery DOD is greater as the voltage sum value is greater.

6. The battery DOD diagnosing apparatus according to claim 4,
   wherein the control unit is configured to divide the plurality of cycles into a plurality of unit sections, calculate a unit sum value for each of the plurality of divided unit sections based on at least one voltage deviation calculated corresponding to a cycle belonging to each of the plurality of divided unit sections, and diagnose a relative DOD in each of the plurality of unit sections for the plurality of battery cells based on a comparison result of unit sum values calculated corresponding to the same unit section.

7. The battery DOD diagnosing apparatus according to claim 6,
   wherein the control unit is configured to select a target cell among the plurality of battery cells, calculate a unit sum value corresponding to the target cell in each of the plurality of unit sections, and diagnose whether the degradation of the target cell is accelerated by comparing the plurality of calculated unit sum values corresponding to the target cell with each other.

8. The battery DOD diagnosing apparatus according to claim 7,
wherein the control unit is configured to diagnose that the degradation of the target cell is accelerated, when the unit sum value increases as the cycle proceeds.

9. A battery pack, comprising the battery DOD diagnosing apparatus according to any one of claims 1 to 8.

10. A battery Degree of Degradation, DOD, diagnosing method, comprising:

a voltage measuring step (S100) of measuring a voltage of each of a plurality of battery cells in each of a plurality of cycles in which charging and discharging is performed;
a voltage deviation calculating step (S200) of calculating a voltage deviation of each cycle for each battery cell based on a reference voltage measured in an initial cycle of each of the plurality of battery cells;
a voltage sum value calculating step (S300) of calculating a voltage sum value for each of the plurality of battery cells by summing the voltage deviation calculated for each of the plurality of battery cells in each cycle from the initial cycle; and
a DOD diagnosing step (S400) of diagnosing a relative DOD of the plurality of battery cells based on the voltage sum value calculated in the voltage sum value calculating step.

**Patentansprüche**

1. Batterieverschlechterungsgrad-, DOD, -Diagnosevorrichtung (100), umfassend:

eine Messeinheit (110), welche dazu eingerichtet ist, eine Spannung jeder einer Mehrzahl von Batteriezellen (B1, B2, B3, B4) in jedem einer Mehrzahl von Zyklen zu messen, in welchen ein Laden und ein Entladen durchgeführt werden, und eine Mehrzahl von Spannungsinformationen für die Mehrzahl von gemessenen Spannungen auszugeben; und
eine Steuereinheit (120), welche dazu eingerichtet ist, die Mehrzahl von Spannungsinformationen zu empfangen, auf Grundlage einer in einem initialen Zyklus jeder der Mehrzahl von Batteriezellen gemessenen Referenzspannung eine Spannungsabweichung zu berechnen, durch ein Summieren der in jedem Zyklus von dem initialen Zyklus für jede der Mehrzahl von Batteriezellen berechneten Spannungsabweichung für jede der Mehrzahl von Batteriezellen einen Spannungssummenwert zu berechnen und auf Grundlage des für jede der Mehrzahl von Batteriezellen berechneten Spannungssummenwerts einen relativen DOD der Mehrzahl von Batteriezellen zu diagnostizieren.

2. Batterie-DOD-Diagnosevorrichtung nach Anspruch 1,
wobei die Messeinheit dazu eingerichtet ist, eine Spannung an einem Messpunkt zu messen, wenn eine vorbestimmte Zeit verstrichen ist, nachdem das Entladen der Mehrzahl von Batteriezellen abgeschlossen ist.

3. Batterie-DOD-Diagnosevorrichtung nach Anspruch 2,
wobei die Steuereinheit dazu eingerichtet ist, eine in dem initialen Zyklus jeder Batteriezelle gemessene Spannung als die Referenzspannung festzulegen und durch ein Berechnen einer Differenz zwischen einer in jedem Zyklus gemessenen Zellenspannung jeder Batteriezelle und der Referenzspannung die Spannungsabweichung zu berechnen.

4. Batterie-DOD-Diagnosevorrichtung nach Anspruch 1,
wobei die Steuereinheit dazu eingerichtet ist, durch ein Vergleichen des für jede der Mehrzahl von Batteriezellen berechneten Spannungssummenwerts miteinander einen relativen DOD der Mehrzahl von Batteriezellen zu diagnostizieren.

5. Batterie-DOD-Diagnosevorrichtung nach Anspruch 4,
wobei die Steuereinheit dazu eingerichtet ist, zu diagnostizieren, dass ein Batterie-DOD größer wird, wenn der Spannungssummenwert größer wird.

6. Batterie-DOD-Diagnosevorrichtung nach Anspruch 4,
wobei die Steuereinheit dazu eingerichtet ist, die Mehrzahl von Zyklen in eine Mehrzahl von Einheitsabschnitten zu unterteilen, auf Grundlage wenigstens einer entsprechend einem zu jedem der Mehrzahl von unterteilten Einheitsabschnitten gehörenden Zyklus berechneten Spannungsabweichung für jeden der Mehrzahl von unterteilten Einheitsabschnitten einen Einheitssummenwert zu berechnen und auf Grundlage eines Vergleichsergebnisses von entsprechend des gleichen Einheitsabschnitts berechneten Einheitssummenwerten in jedem der Mehrzahl von Einheitsabschnitten für die Mehrzahl von Batteriezellen einen relativen DOD zu diagnostizieren.

7. Batterie-DOD-Diagnosevorrichtung nach Anspruch 6,
wobei die Steuereinheit dazu eingerichtet ist, unter der Mehrzahl von Batteriezellen eine Zielzelle auszuwählen, in jedem der Mehrzahl von Einheitsabschnitten einen der Zielzelle entsprechenden Einheitssummenwert zu berechnen und durch ein Vergleichen der Mehrzahl von der Zielzelle entsprechenden berechneten Einheitssummenwerte miteinander zu diagnostizieren, ob die Verschlechterung der Zielzelle beschleunigt ist.

8. Batterie-DOD-Diagnosevorrichtung nach Anspruch 7,
   wobei die Steuereinheit dazu eingerichtet ist, zu diagnostizieren, dass die Verschlechterung der Zielzelle beschleunigt wird, wenn sich der Einheitssummenwert erhöht, wenn der Zyklus fortschreitet.

9. Batteriepack, umfassend die Batterie-DOD-Diagnosevorrichtung nach einem der Ansprüche 1 bis 8.

10. Batterieverschlechterungsgrad-, DOD, -Diagnoseverfahren, umfassend:

    einen Spannungsmessschritt (S100) eines Messens einer Spannung jeder einer Mehrzahl von Batteriezellen in jedem einer Mehrzahl von Zyklen, in welchen ein Laden und ein Entladen durchgeführt wird;
    einen Spannungsabweichungsberechnungsschritt (S200) eines Berechnens einer Spannungsabweichung jedes Zyklus für jede Batteriezelle auf Grundlage einer in einem initialen Zyklus jeder der Mehrzahl von Batteriezellen gemessenen Referenzspannung;
    einen Spannungssummenwertberechnungsschritt (S300) eines Berechnens eines Spannungssummenwerts für jede der Mehrzahl von Batteriezellen durch ein Summieren der in jedem Zyklus von dem initialen Zyklus für jede der Mehrzahl von Batteriezellen berechneten Spannungsabweichung; und
    einen DOD-Diagnoseschritt (S400) eines Diagnostizierens eines relativen DOD der Mehrzahl von Batteriezellen auf Grundlage des in dem Spannungssummenwertberechnungsschritt berechneten Spannungssummenwerts.

**Revendications**

1. Appareil de diagnostic (100) du degré de dégradation, DOD, d'une batterie, comprenant :

    une unité de mesure (110) configurée pour mesurer une tension de chacun d'une pluralité d'éléments de batterie (B1, B2, B3, B4) dans chacun d'une pluralité de cycles dans lesquels une charge et une décharge sont effectuées, et pour délivrer une pluralité d'informations de tension pour la pluralité de tensions mesurées ; et

    une unité de commande (120) configurée pour recevoir la pluralité d'informations de tension, calculer un écart de tension de chaque cycle pour chaque élément de batterie sur la base d'une tension de référence mesurée dans un cycle initial de chacun de la pluralité d'éléments de batterie, calculer une valeur de somme de tension pour chacun de la pluralité d'éléments de batterie en additionnant l'écart de tension calculé pour chacun de la pluralité d'éléments de batterie dans chaque cycle à partir du cycle initial, et diagnostiquer un DOD relatif de la pluralité d'éléments de batterie sur la base de la valeur de somme de tension calculée pour chacun de la pluralité d'éléments de batterie.

2. Appareil de diagnostic de DOD de batterie selon la revendication 1,
   dans lequel l'unité de mesure est configurée pour mesurer une tension à un point de mesure lorsqu'un temps prédéterminé s'écoule après que la décharge de la pluralité d'éléments de batterie est terminée.

3. Appareil de diagnostic de DOD de batterie selon la revendication 2,
   dans lequel l'unité de commande est configurée pour définir une tension mesurée dans le cycle initial de chaque élément de batterie comme étant la tension de référence et calculer l'écart de tension en calculant une différence entre une tension d'élément de chaque élément de batterie mesurée dans chaque cycle et la tension de référence.

4. Appareil de diagnostic de DOD de batterie selon la revendication 1,
   dans lequel l'unité de commande est configurée pour diagnostiquer un DOD relatif de la pluralité d'éléments de batterie en comparant les valeurs de somme de tension calculées pour chacun de la pluralité d'éléments de batterie entre elles.

5. Appareil de diagnostic de DOD de batterie selon la revendication 4,
   dans lequel l'unité de commande est configurée pour diagnostiquer qu'un DOD de batterie est plus élevé lorsque la valeur de somme de tension est plus élevée.

6. Appareil de diagnostic de DOD de batterie selon la revendication 4,
   dans lequel l'unité de commande est configurée pour diviser la pluralité de cycles en une pluralité de sections unitaires, calculer une valeur de somme unitaire pour chacune de la pluralité de sections unitaires divisées sur la base d'au moins un écart de tension calculé correspondant à un cycle appartenant à chacune de la pluralité de sections unitaires divisées, et diagnostiquer un DOD relatif dans chacune de la pluralité de sections unitaires pour la pluralité d'éléments de batterie sur la base d'un résultat de comparaison de valeurs de somme unitaire calculées correspondant à la même section unitaire.

7. Appareil de diagnostic de DOD de batterie selon la revendication 6,
dans lequel l'unité de commande est configurée pour sélectionner un élément cible parmi la pluralité d'éléments de batterie, calculer une valeur de somme unitaire correspondant à l'élément cible dans chacune de la pluralité de sections unitaires, et diagnostiquer si la dégradation de l'élément cible est accélérée en comparant la pluralité de valeurs de somme unitaire calculées correspondant à l'élément cible entre elles.

8. Appareil de diagnostic de DOD de batterie selon la revendication 7,
dans lequel l'unité de commande est configurée pour diagnostiquer que la dégradation de l'élément cible est accélérée, lorsque la valeur de somme unitaire augmente au fur et à mesure que le cycle progresse.

9. Bloc-batterie comprenant l'appareil de diagnostic de DOD de batterie selon l'une quelconque des revendications 1 à 8.

10. Procédé de diagnostic du degré de dégradation, DOD, d'une batterie, comprenant :

une étape de mesure de tension (S100) pour mesurer une tension de chacun d'une pluralité d'éléments de batterie dans chacun d'une pluralité de cycles dans lesquels une charge et une décharge sont effectuées ;
une étape de calcul d'écart de tension (S200) pour calculer un écart de tension de chaque cycle pour chaque élément de batterie sur la base d'une tension de référence mesurée dans un cycle initial de chacun de la pluralité d'éléments de batterie ;
une étape de calcul de valeur de somme de tension (S300) pour calculer une valeur de somme de tension pour chacun de la pluralité d'éléments de batterie en additionnant l'écart de tension calculé pour chacun de la pluralité d'éléments de batterie dans chaque cycle à partir du cycle initial ; et
une étape de diagnostic de DOD (S400) pour diagnostiquer un DOD relatif de la pluralité d'éléments de batterie sur la base de la valeur de somme de tension calculée dans l'étape de calcul de valeur de somme de tension.

FIG. 1

100

BATTERY DOD DIAGNOSING APPARATUS

| MEASURING UNIT | 110 |
| CONTROL UNIT | 120 |
| STORAGE UNIT | 130 |

FIG. 2

1

BATTERY PACK

10

BATTERY MODULE

B1 — FIRST BATTERY CELL

B2 — SECOND BATTERY CELL

B3 — THIRD BATTERY CELL

B4 — FOURTH BATTERY CELL

100

BATTERY DOD DIAGNOSING APPARATUS

MEASURING UNIT — 110

CONTROL UNIT — 120

STORAGE UNIT — 130

FIG. 3

FIG. 4

FIG. 5

FIG. 6

FIG. 7

FIG. 8

FIG. 9

START

S100

VOLTAGE MEASURING STEP

S200

VOLTAGE DEVIATION CALCULATING STEP

S300

VOLTAGE SUM VALUE CALCULATING STEP

S400

DOD DIAGNOSING STEP

END

**REFERENCES CITED IN THE DESCRIPTION**

**Patent documents cited in the description**

- KR 101882287 B1
- US 2014278169 A1
- JP 2017016991 A
- US 2019195942 A1
- US 2015168498 A1